# EUROPEAN PATENT SPECIFICATION

(11) **EP 0 453 133 B1**
(45) Date of publication and mention of the grant of the patent: **09.07.1997**
(21) Application number: 91302988.0
(22) Date of filing: 04.04.1991
(51) Int. Cl.: G03F 1/14

(54) **Method and apparatus for manufacture of X-ray mask**
Verfahren und Vorrichtung zur Herstellung einer Röntgenmaske
Procédé et appareil pour la fabrication de masques à rayons X

(30) Priority: 12.04.1990 JP 94937/90
(43) Date of publication of application: 23.10.1991
(73) Proprietor: CANON KABUSHIKI KAISHA, Tokyo (JP)
(72) Inventor: Fujioka, Hidehiko, Ohta-ku, Tokyo (JP); Miyachi, Takeshi, Ohta-ku, Tokyo (JP); Chiba, Yuji, Ohta-ku, Tokyo (JP); Mizusawa, Nobutoshi, Ohta-ku, Tokyo (JP); Kariya, Takao, Ohta-ku, Tokyo (JP); Uzawa, Shunichi, Ohta-ku, Tokyo (JP); Fukuda, Yasuaki, Ohta-ku, Tokyo (JP)
(74) Representative: Beresford, Keith Denis Lewis

(56) References cited:
- PATENT ABSTRACTS OF JAPAN, vol. 14, no. 32 (E-876) 22 January 1990 & JP-A-1 266 722
- PATENT ABSTRACTS OF JAPAN, vol. 13, no. 226 (E-763) 31 July 1987 & JP-A-1 036 019
- PATENT ABSTRACTS OF JAPAN, vol. 12, no. 412 (E-676) 16 December 1988 & JP-A-63 150 918

## Description

### FIELD OF THE INVENTION AND RELATED ART

This invention relates to a method and apparatus for manufacture of an X-ray mask usable in an X-ray exposure apparatus, for manufacture of semiconductor devices.

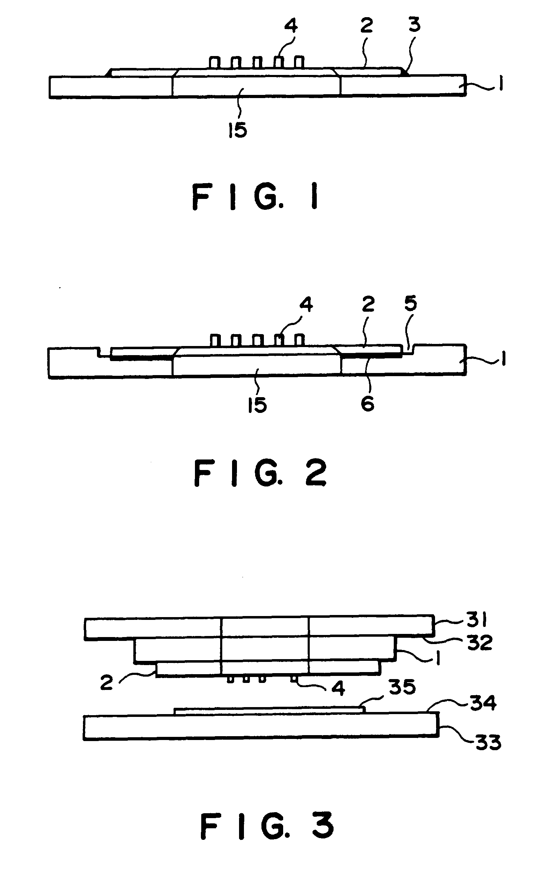

Figure 1 shows an X-ray mask structure of known type. Denoted at 1 is a supporting frame, denoted at 2 is a mask substrate, denoted at 3 is an adhesive agent, and denoted at 4 is a mask pattern. The mask substrate 2 is placed on the supporting frame 1, and the adhesive agent 3 is applied to the whole periphery of the mask substrate 2, whereby it is fixed. The supporting frame 1 has a ring-like shape, having an opening 15 formed at its center. The mask pattern 4 is made of an X-ray absorptive material such as Au, for example. It is formed on a thin film of a few micron thickness, made of an inorganic material such as SiN or SiC, for example.

The mask substrate 2 is made of an inorganic material, and the thin film can be formed by back-etching the mask substrate 2. The supporting frame 1 is provided by a Ti plate of a thickness of about 0.5 - 3 mm.

Figure 2 shows another X-ray mask structure of known type. In this example, a recess 5 is formed in a supporting frame 1 and, in this recess 5, a mask substrate 2 is fixed by using an adhesive agent layer 6.

In the X-ray lithographic, as best seen in Figure 3, a mask is attached to a reference surface 32 of a mask chuck 31 of an exposure apparatus, while a semiconductor wafer 35 is attached to a reference surface 34 of a wafer chuck 33 of the exposure apparatus. The mask and the wafer should be held precisely with a gap of micron order, and additionally, they should be held in parallel to each other. In consideration thereof, in conventional X-ray masks, many efforts have been made to increase the flatness of the surface (mask surface) on which a mask pattern 4 is formed and which is to be opposed to a wafer. Such a method/apparatus is known from JP-A-1 266 722. Another example is disclosed in JP-A-1 036 019.

However, if a mask substrate or a supporting frame therefor, constituting an X-ray mask, has nonuniform thickness or if the mask substrate and the supporting frame are fixed by adhesion to each other with mutual inclination, only increasing the flatness of the mask surface as in conventional X-ray masks does not assure the parallelism of the mask surface of the X-ray mask, as the same is mounted to a mask chuck, with respect to a reference plane defined on the mask chuck side. Such an error in the parallelism of the mask surface results in failure of parallelism between the mask and the wafer and, therefore, the precision of pattern transfer is degraded.

If such an error in parallelism is to be corrected in the exposure apparatus, limitations may be applied to an autoalignment operation or an autofocusing operation. Furthermore, an additional stroke may be necessary for a six-axis stage for moving the wafer. Also, it may require use of another six-axis stage at the mask side. Thus, the structure of the exposure apparatus may be complicated considerably.

### SUMMARY OF THE INVENTION

According to one aspect, the present invention provides a method of producing a mask for use in printing a pattern on a semiconductor substrate, wherein the mask comprises (i) a mask substrate having a mask surface for bearing a mask pattern, and (ii) a supporting frame having a reference surface which is to be attracted to a mask chuck when the pattern is printed on the semiconductor substrate, said method comprising the steps of: holding the mask substrate and the supporting frame adjacent each other using a first and second holding members; moving said mask substrate and said supporting frame relative to each other; and fixing said mask substrate to said supporting frame when the mask surface of said mask substrate is in a predetermined position relative to the reference surface of said supporting frame; characterised in that an attracting force is applied to said mask surface of the mask substrate through the first holding member, to hold the mask substrate thereto; in that an attracting force is applied to said reference surface of said supporting frame through the second holding member, to hold the supporting frame thereto; and in that at least one of (i) the spacing between the first and second holding members, and (ii) the tilt of one of the first and second holding members relative to the other is adjusted on the basis of one of (a) an output of gap sensor means for detecting a gap between the first and second holding members, or (b) a spacer acting between the first and second holding members.

According to another aspect, the present invention provides an apparatus for producing a mask for use in printing a pattern on a semiconductor substrate, wherein the mask comprises a mask substrate having a mask surface on which a corresponding pattern is to be formed and a supporting frame having a reference surface which is to be attracted to a mask chuck when the pattern is printed on the semiconductor substrate, said apparatus comprising: a first holding member provided adjacent to said mask surface of the mask substrate, for holding the mask substrate; a second holding member provided adjacent the reference surface of the supporting frame, for holding the supporting frame; means for moving said mask substrate and said supporting frame relative to each other; and fixing means for fixing said mask substrate to said supporting frame; characterised in that said first holding member has associated therewith means for applying an attractive force to said mask surface for fixing said mask substrate to said first holding member; in that said second holding member has associated therewith means for applying an attractive force to said reference surface for fixing said supporting frame to said second holding member; and in that said moving means is arranged to adjust at least one of (i) the spacing between the first and second holding members and (ii) the tilt of one of the first and second holding members relative to the other, on the basis of one of (a) an output of gap sensor means arranged to detect a gap between the first and second holding members, or (b) a spacer acting between the first and second holding members.

These and other aspects, features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a sectional view of an X-ray mask structure of known type.

Figure 2 is a sectional view of another X-ray mask structure of known type.

Figure 3 is a sectional view, schematically showing a major part of an X-ray exposure apparatus wherein an X-ray mask and a wafer are attached to a mask chuck and a wafer chuck, respectively, of the exposure apparatus.

Figure 4 is a sectional view, schematically showing a major part of an X-ray mask manufacturing apparatus according to a first embodiment of the present invention.

Figure 5 is a sectional view, schematically showing an X-ray mask manufacturing apparatus according to a second embodiment of the present invention.

Figure 6 is a sectional view of an X-ray mask structure, manufactured in an X-ray mask manufacturing apparatus according to the present invention.

### DESCRIPTION OF THE PREFERRED EMBODIMENTS

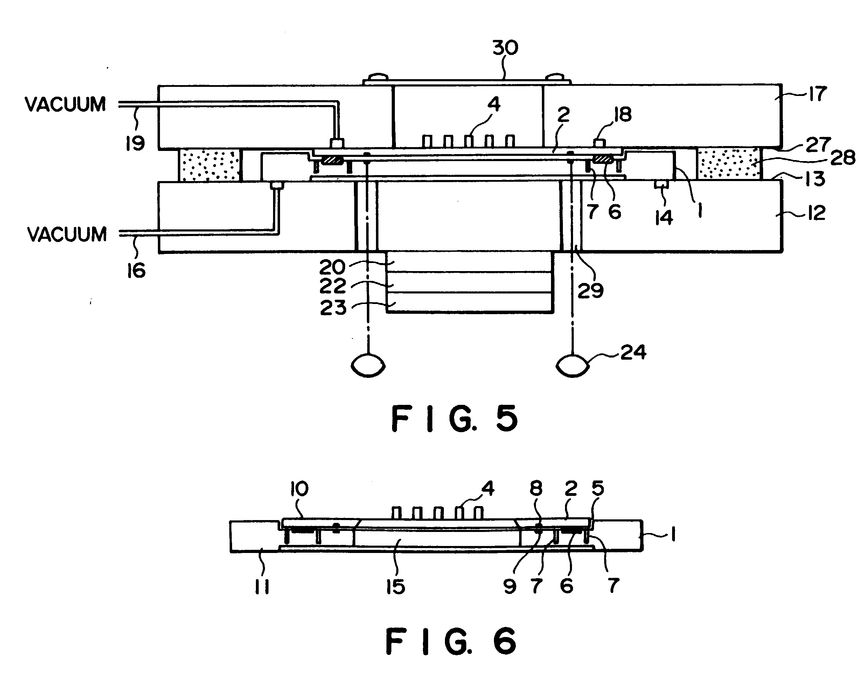

Referring now to Figure 6, there is shown an example of X-ray mask which can be manufactured by an X-ray mask manufacturing apparatus according to the present invention. Like numerals as of those in Figures 1 and 2 are assigned to corresponding elements, and explanation therefor is omitted here. In this example, a recess 5 is formed in a supporting frame 1 which is made of Pyrex, crystal or the like. In this recess 5, a mask substrate 2 is fixed by using an adhesive agent layer 6. Slit-like stress releasing grooves 7 are formed in the supporting frame 1, at the opposite sides of the adhesive agent layer 6, as illustrated. The mask substrate 2 has formed thereon alignment marks 8 which are to be aligned with alignment marks 9, provided on the supporting frame 1, for the mutual positioning of the mask substrate 2 and the supporting frame 1.

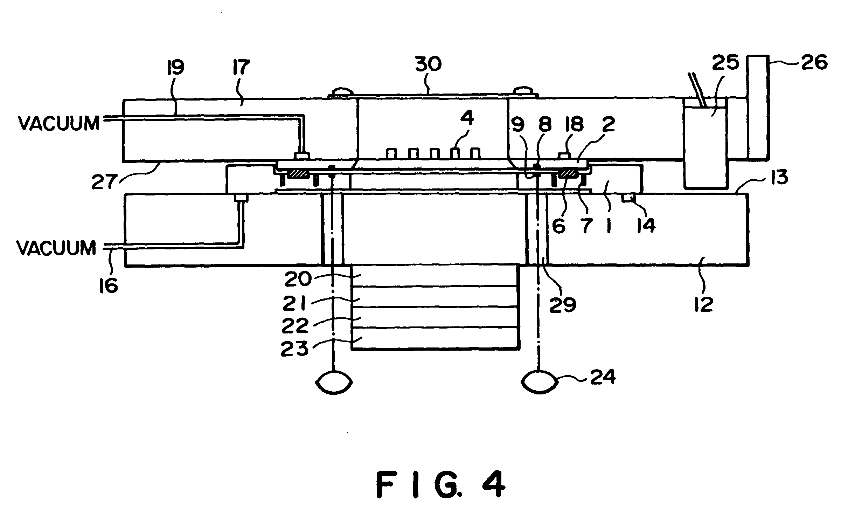

Figure 4 shows the structure of an X-ray mask manufacturing apparatus according to a first embodiment of the present invention. Mask substrate 2 is attracted, by vacuum, to a mask substrate attracting surface 27 of a first upper base 17, the vacuum from a vacuum pump (not shown) being applied thereto through a vacuum groove 18 and a vacuum pipe 19. The mask surface (upper surface) 10 of the mask substrate 2 (Figure 6) has been finished to attain predetermined flatness. The mask substrate attracting surface 27 of the first base 17, to be opposed to the mask surface, has been finished in a similar manner to attain predetermined high flatness. On the other hand, a supporting frame 1 is attracted, by vacuum, to a supporting frame attracting surface of a second lower base 12, the vacuum from a vacuum pump (not shown) being applied thereto through a vacuum groove 14 and a vacuum pipe 16. The bottom surface 11 of the supporting frame 1 (Figure 6) as well as the supporting frame attracting surface 13 of the second base 12, engageable with the bottom surface 11 of the supporting frame, have been finished to attain high flatness, respectively. To the second base 12, a θ stage 20 for θ rotation (rotation about Z axis), a tilt stage 21 for adjustment of inclination angle as well as an X stage 22 and a Y stage 23 for positional adjustment in respect to X and Y directions, are coupled. On the other hand, to the first base 17, a Z stage 26 for positional adjustment in Z direction (a direction perpendicular to the mask surface) is coupled. Denoted at 24 is a microscope for observing alignment marks 8 and 9 through bores 29 formed in the base 17, for mutual positioning of the mask substrate 2 and the supporting frame 1. Denoted at 25 is a gap sensor for detecting the spacing between the mask substrate attracting surface of the first base 17 and the supporting frame attracting surface of the second base 12. Preferably, three or more gap sensors 25 may be provided. Denoted at 30 is a mask protection cover.

In the described structure, the first and second bases 17 and 12 are spaced from each other with an interval sufficient for allowing mounting of the mask substrate and the supporting frame to the first and second bases, respectively and, in that state, the mask substrate and the supporting frame are mounted on the first and second bases, respectively. Then, the θ stage 20 as well as the X stage 22 and the Y stage 23 are actuated while observing the alignment marks 8 and 9 through the microscope 24, the relative position of the mask substrate 2 and the supporting frame 1 are adjusted so that they are aligned with each other. Adhesive agent 6 may be applied to the mask substrate 2 and/or the supporting frame 1 beforehand. However, it may be applied to one or both of them after they are aligned with each other. As for the adhesive agent 6, an adhesive material which is less in quantity of contraction by the setting and which has high viscosity and is long in setting time, is preferable. Alternatively, photo-setting type adhesive material may preferably be used.

After the alignment operation, three or more gap sensors 25 are used to measure the interval between the mask substrate attracting surface and the supporting frame attracting surface of the first and second bases and, on the basis of the measurement, the tilt stage 21 and the Z stage 26 are actuated under servo control, such that the mask substrate attracting surface and the supporting frame attracting surface are opposed to each other with a predetermined interval. With this predetermined interval, the mask substrate 2 and the supporting frame 1 can be sufficiently fixed to each other with the intervention of the adhesive agent 6 and, additionally, the parallelism between the mask surface 10 of the mask substrate and the bottom surface 11 of the supporting frame is not affected by the flatness of each of the opposed surfaces of the mask substrate 2 and the supporting frame 1. The first and second bases are maintained at the predetermined interval until the adhesive agent 6 is sufficiently set. When this is accomplished, the assembling of the X-ray mask is completed. In the present embodiment, as the sensors 25, electrostatic capacitance type sensors are used.

With the method described above, an assembled X-ray mask has a mask surface, to be opposed to a wafer, and a mask chuck mounting surface, at a side thereof remote from the mask surface, which surfaces are exactly in parallel to each other. The attraction of the supporting frame 1 and the mask substrate 2 to the bases 12 and 17, respectively, is not limited to vacuum attraction. An electrostatic attracting method or any other attracting method may be used.

Figure 5 shows the structure of a mask manufacturing apparatus according to a second embodiment of the present invention. In this embodiment, a ring-like spacer 28 is interposed between upper and lower bases 12 and 17, wherein the spacer 28 has engaging surfaces, engageable with the upper and lower bases, each engaging surface having been finished to attain high flatness. By means of the spacer 28, the opposed surfaces of the upper and lower bases 12 and 17 can be held in parallel to each other and at a predetermined interval. Therefore, in the present embodiment, the gap detecting sensors 25, the tilt stage 21 as well as the Z stage 26 of the Figure 4 embodiment may be omitted. The remaining portion of this embodiment is essentially the same as the preceding embodiment in respect to structure and operation.

While the invention has been described with reference to the structures disclosed herein, it is not confined to the details set forth and this application is intended to cover such modifications or changes as may come within the scope of the following claims.

## Claims

1. A method of producing a mask for use in printing a pattern on a semiconductor substrate, wherein the mask comprises (i) a mask substrate (2) having a mask surface for bearing a mask pattern (4), and (ii) a supporting frame (1) having a reference surface which is to be attracted to a mask chuck when the pattern is printed on the semiconductor substrate, said method comprising the steps of:
holding the mask substrate (2) and the supporting frame (1) adjacent each other using a first and second holding members (17, 12);
moving said mask substrate (2) and said supporting frame (1) relative to each other; and
fixing said mask substrate (2) to said supporting frame (1) when the mask surface of said mask substrate (2) is in a predetermined position relative to the reference surface of said supporting frame (1);
characterised in that an attracting force is applied to said mask surface of the mask substrate (2) through the first holding member (17), to hold the mask substrate (2) thereto;
in that an attracting force is applied to said reference surface of said supporting frame (1) through the second holding member (12), to hold the supporting frame (2) thereto;
and in that at least one of (i) the spacing between the first and second holding members (17, 12), and (ii) the tilt of one of the first and second holding members (17, 12) relative to the other is adjusted on the basis of one of (a) an output of gap sensor means (25) for detecting a gap between the first and second holding members (17, 12), or (b) a spacer (28) acting between the first and second holding members (17, 12).

2. A method according to claim 1, further comprising (i) detecting an alignment mark (8) formed on the mask substrate (2) and an alignment mark (9) formed on the supporting frame (1) and (ii) moving one of the mask substrate (2) or the supporting frame (1) relative to the other on the basis of the detection in said detecting step to adjust the relative position of the mask substrate (2) and the supporting frame (1).

3. A method according to claim 1 or 2, wherein said fixing step comprises providing an adhesive agent (6) between a non-mask surface of the mask substrate (2) and a non-reference surface of the supporting frame (1), and wherein, until the adhesive agent is set, the first holding member (17) continues to hold the mask substrate (2) while the second holding member (12) continues to hold the supporting frame (1).

4. A method according to any preceding claim, wherein said attractive force is provided by means of a vacuum or is electrostatic in nature.

5. A method according to any preceding claim, wherein an absorbing layer (4) is formed on the mask surface of the mask substrate (2) for absorbing X-rays.

6. A method according to any preceding claim, wherein said gap sensor means (25) comprises three or more gap sensors.

7. An apparatus for producing a mask for use in printing a pattern on a semiconductor substrate, wherein the mask comprises a mask substrate (2) having a mask surface on which a corresponding pattern (4) is to be formed and a supporting frame (1) having a reference surface which is to be attracted to a mask chuck when the pattern is printed on the semiconductor substrate, said apparatus comprising:
a first holding member (17) provided adjacent to said mask surface of the mask substrate (2), for holding the mask substrate (2);
a second holding member (12) provided adjacent the reference surface of the supporting frame, for holding the supporting frame (1);
means (20-23, 26; 20, 22, 23) for moving said mask substrate (2) and said supporting frame (1) relative to each other; and
fixing means (6) for fixing said mask substrate (2) to said supporting frame (1);
characterised in that said first holding member (17) has associated therewith means (19) for applying an attractive force to said mask surface for fixing said mask substrate (2) to said first holding member (17);
in that said second holding member (12) has associated therewith means (16) for applying an attractive force to said reference surface for fixing said supporting frame (1) to said second holding member (12);
and in that said moving means (20-23, 26; 20, 22, 23) is arranged to adjust at least one of (i) the spacing between the first and second holding members (17, 12) and (ii) the tilt of one of the first and second holding members (17, 12) relative to the other, on the basis of one of (a) an output of gap sensor means (25) arranged to detect a gap between the first and second holding members (17, 12), or (b) a spacer (28) acting between the first and second holding members (17, 12).

8. An apparatus according to claim 7 further comprising means (24, 29) for detecting an alignment mark (8) found on the mask substrate (2) and an alignment mark (9) found on the supporting frame (1), and wherein said moving means (20-23, 26; 20, 22, 23) is arranged to move one of the mask substrate (2) or the supporting frame (1) relative to the other on the basis of the output of said detecting means (24, 29).

9. An apparatus according to claim 7 or 8 wherein said means (16, 19) for applying an attractive force to said mask surface or to said reference surface is a vacuum pump or an electro-static attraction device.

10. An apparatus according to claims 7, 8 or 9, wherein said gap sensor means (25) comprises three or more gap sensors.

11. A semiconductor device manufactured using a mask made in accordance with the method of any of claims 1 to 6 or made using an apparatus according to any of claims 7 to 10.

12. A method of manufacturing a semiconductor device comprising the step of using a mask made in accordance with the method of any of claims 1 to 6 or made using an apparatus according to any of claims 7 to 10 to expose the semiconductor substrate.

## Patentansprüche

1. Verfahren zur Herstellung einer Maske zur Verwendung beim Drucken eines Musters auf ein Halbleitersubstrat, wobei die Maske folgendes aufweist, (i) ein Maskensubstrat (2) mit einer Maskenoberfläche zum Tragen eines Maskenmusters (4), und (ii) einen Stützrahmen (1) mit einer Referenzoberfläche, die an ein Maskenfutter angezogen werden soll, wenn das Muster auf das Halbleitersubstrat gedruckt wird, wobei das Verfahren die folgenden Schritte aufweist:
Halten des Maskensubstrates (2) und des Stützrahemens (1) nebeneinander, unter Verwendung erster und zweiter Halteelemente (17, 12);
Bewegen des Maskensubstrates (2) und des Stützrahmens (1) relativ zueinander; und
Fixieren des Maskensubstrates (2) an dem Stützrahmen (1), wenn die Maskenoberfläche des Maskensubstrates (2) in einer vorbestimmten Position relativ zur Referenzoberfläche des Stützrahmens (1) liegt;
dadurch gekennzeichnet, daß durch das erste Halteelement (17) eine Anziehungskraft auf die Maskenoberfläche des Maskensubstrates (2) aufgebracht wird, um das Maskensubstrat (2) darauf zu halten;
und daß eine Anziehungskraft auf die Referenzoberfläche des Stützrahmens (2) durch das zweite Halteelement (12) aufgebracht wird, um den Stützrahmen (2) darauf zu halten;
und dadurch, daß zumindest einer (i) der Abstände zwischen den ersten und zweiten Halteelementen (17, 12) und (ii) die Neigung eines der ersten und zweiten Halteelemente (17, 12) relativ zueinander eingestellt wird auf der Grundlage (a) einer Ausgabe einer Spaltsensorvorrichtung (25) zur Erfassung eines Spaltes zwischen den ersten und zweiten Halteelementen (17, 12), oder (b) ein Abstandhalter (28), der zwischen den ersten und zweiten Halteelementen (17, 12) wirkt.

2. Verfahren gemäß Anspruch 1, desweiteren aufweisend (i) das Erfassen einer Übereinstimmungsmarkierung (8), welche auf dem Maskensubstrat (2) gebildet ist und eine Übereinstimmungsmarkierung (9), die auf dem Stützrahmen (1) gebildet ist, und (ii) Bewegen von einem der Maskensubstrate (2) oder des Stützrahmens (1) relativ zueinander auf der Grundlage der Erfassung in dem Erfassungsschritt, um die Relativposition des Maskensubstrates (2) und des Stützrahmens (1) einzustellen.

3. Verfahren gemäß Anspruch 1 oder 2, wobei der Fixierschritt das Vorsehen eines Klebers (6) zwischen einer Nicht-Maskenoberfläche des Maskensubstrates (2) und einer Nicht-Referenzoberfläche des Stützrahmens (1) aufweist und wobei das erste Halteelement (17) fortfährt, das Maskensubstrat (2) zu halten solange der Kleber aufgebracht wird, während das zweite Halteelement (12) fortfährt, den Stützrahmen (1) zu halten.

4. Verfahren gemäß einem der vorhergehenden Ansprüche, wobei die Anziehungskraft mittels Unterdruck geschaffen wird oder von elektrostatischer Natur ist.

5. Verfahren gemäß einem der vorhergehenden Ansprüche, wobei auf der Maskenoberfläche des Maskensubstrates (2) eine Absorbierschicht (4) zum Absorbieren von Röntgenstrahlen gebildet ist.

6. Verfahren gemäß einem der vorgehenden Ansprüche, wobei die Spaltsensorvorrichtung (25) drei oder mehrere Spaltsensoren aufweist.

7. Vorrichtung zur Herstellung einer Maske zum Gebrauch beim Drucken eines Musters auf ein Halbleitersubstrat, wobei die Maske ein Maskensubstrat (2) mit einer Maskenoberfläche aufweist, auf der ein entsprechendes Muster (4) ausgebildet werden soll und einen Stützrahmen (1) aufweist, der eine Referenzoberfläche hat, die an ein Maskenfutter angezogen werden soll, wenn das Muster auf das Halbleitersubstrat gedruckt wird, wobei die Vorrichtung folgendes aufweist:
ein erstes Halteelement (17), welches angrenzend an die Maskenoberfläche des Maskensubstrates (2) zum Halten des Maskensubstrates (2) vorgesehen ist;
ein zweites Halteelement (12), das angrenzend an die Referenzoberfläche des Stützrahmens zum Halten des Stützrahmens (1) vorgesehen ist;
Vorrichtungen (20-23, 26; 20, 22, 23) zum Bewegen des Maskensubstrates (2) und des Stützrahmens (1) relativ zueinander; und
eine Fixiervorrichtung (6) zum Fixieren des Maskensubstrates (2) am Stützrahmen (1);
dadurch gekennzeichnet, daß das erste Halteelement (17) zugehörige Mittel (19) zur Aufbringung einer Anziehungskraft auf die Maskenoberfläche zum Fixieren des Maskensubstrates (2) auf dem ersten Halteelement (17) hat; und daß das zweite Halteelement (12) zugehörige Mittel (16) zur Aufbringung einer Anziehungskraft auf die Referenzoberfläche zum Fixieren des Stützrahmens (1) an dem zweiten Halteelement (12) hat;
und daß die Bewegungsvorrichtung (20-23, 26; 20, 22, 23) angeordnet ist, um zumindest einen (i) der Abstände zwischen den ersten und zweiten Halteelementen (17, 12) einzustellen und (ii) die Neigung eines der ersten und zweiten Halteelemente (17, 12) relativ zueinander auf der Grundlage (a) eines Ausgangs eines Spaltsensors (25), der angeordnet ist um einen Spalt zwischen den ersten und zweiten Halteelementen (17, 12) zu erfassen, oder (b) eines Abstandhalters (28), der zwischen den ersten und zweiten Halteelementen (17, 12) wirkt.

8. Vorrichtung gemäß Anspruch 7, die desweiteren eine Vorrichtung (24, 29) zur Erfassung einer Übereinstimmungsmarkierung (8), die auf dem Maskensubstrat (2) errichtet wurde, und einer Übereinstimmungsmarkierung (9), die auf dem Stützrahmen (1) errichtet wurde, aufweist und wobei die Bewegungsvorrichtung (20-23, 26; 20, 22, 23) angeordnet ist, um eines der Maskensubstrate (2) oder des Stützrahmens (1) relativ zu dem anderen auf der Grundlage des Ausganges der Erfassungsvorrichtung (24, 29) zu bewegen.

9. Vorrichtung gemäß Anspruch 7 oder 8, wobei die Vorrichtung (16, 19) zur Aufbringung einer Anziehungskraft auf die Maskenoberfläche oder die Referenzoberfläche eine Vakuumpumpe oder eine elektrostatische Anziehungsvorrichtung ist.

10. Vorrichtung gemäß den Ansprüchen 7, 8 oder 9, wobei die Spaltsensorvorrichtung (25) drei oder mehrere Spaltsensoren aufweist.

11. Halbleitervorrichtung, hergestellt unter Verwendung einer Maske, die gemäß dem Verfahren nach einem der Ansprüche 1 bis 6 hergestellt wird oder die unter Verwendung einer Vorrichtung gemäß einem der Ansprüche 7 bis 10 hergestellt wird.

12. Verfahren zur Herstellung einer Halbleitervorrichtung, die den Schritt der Verwendung einer Maske gemäß dem Verfahren gemäß einem der Ansprüche 1 bis 6 aufweist oder die unter Verwendung einer Vorrichtung gemäß einem der Ansprüche 7 bis 10 hergestellt wird, um das Halbleitersubstrat hervorzubringen.

## Revendications

1. Procédé de production d'un masque à utiliser dans l'impression d'un motif sur un substrat semiconducteur, dans lequel le masque comporte (i) un substrat de masque (2) ayant une surface de masque destinée à porter un motif (4) de masque, et (ii) un bâti (1) de support présentant une surface de référence destiné à être attiré sur un plateau de montage de masque lorsque le motif est imprimé sur le substrat semiconducteur, ledit procédé comprenant les étapes dans lesquelles :
on maintient le substrat (2) de masque et le bâti (1) de support adjacents l'un à l'autre en utilisant des premier et second éléments de maintien (17, 12) ;
on déplace ledit substrat (2) de masque et ledit bâti (1) de support l'un par rapport à l'autre ; et
on fixe ledit substrat (2) de masque audit bâti (1) de support lorsque la surface de masque dudit substrat (2) de masque est dans une position prédéterminée par rapport à la surface de référence dudit bâti (1) de support ;
caractérisé en ce qu'une force d'attraction est appliquée à ladite surface de masque dudit substrat (2) de masque à travers le premier élément (17) de maintien, afin d'y maintenir le substrat (2) de masque ;
en ce qu'une force d'attraction est appliquée à ladite surface de référence dudit bâti (1) de support à travers le second élément (12) de maintien, afin d'y maintenir le bâti (1) de support ;
et en ce qu'au moins l'un de (i) l'écartement entre les premier et second éléments (17, 12) de maintien, et (ii) l'inclinaison de l'un des premier et second éléments (17, 12) de maintien par rapport à l'autre est ajusté sur la base de l'un de (a) un signal de sortie d'un moyen capteur d'intervalle (25) destiné à détecter un intervalle entre les premier et second éléments (17, 12) de maintien, ou (b) une entretoise (28) agissant entre les premier et second éléments (17, 12) de maintien.

2. Procédé selon la revendication 1, comprenant en outre (i) la détection d'un repère (8) d'alignement formé sur le substrat (2) de masque et un repère (9) d'alignement formé sur le bâti (1) de support et (ii) le déplacement de l'un du substrat (2) de masque ou du bâti (1) de support par rapport à l'autre sur la base de la détection effectuée dans ladite étape de détection pour ajuster les positions relatives du substrat (2) de masque et du bâti (1) de support.

3. Procédé selon la revendication 1 ou 2, dans lequel ladite étape de fixation comprend l'utilisation d'un agent adhésif (6) entre une surface de non-masque du substrat (2) de masque et une surface de non-référence du bâti (1) de support, et dans lequel le premier élément (17) de maintien continue de maintenir le substrat (2) de masque, tandis que le second élément (12) de maintien continue de maintenir le bâti de support (1) jusqu'à ce que l'agent adhésif ait pris.

4. Procédé selon l'une quelconque des revendications précédentes, dans lequel ladite force d'attraction est produite au moyen d'une dépression ou est de nature électrostatique.

5. Procédé selon l'une quelconque des revendications précédentes, dans lequel une couche absorbante (4) est formée sur la surface de masque du substrat (2) de masque pour absorber des rayons X.

6. Procédé selon l'une quelconque des revendications précédentes, dans lequel ledit moyen capteur d'intervalle (25) comprend trois ou plus de trois capteurs d'intervalle.

7. Appareil pour produire un masque à utiliser dans l'impression d'un motif sur un substrat semiconducteur, dans lequel le masque comporte un substrat (2) de masque ayant une surface de masque sur laquelle un motif correspondant (4) doit être formé et un bâti (1) de support ayant une surface de référence destiné à être attiré sur un plateau de montage de masque lorsque le motif est imprimé sur le substrat semiconducteur, ledit appareil comportant :
un premier élément (17) de maintien placé de façon à être adjacent à ladite surface de masque du substrat (2) de masque, pour maintenir le substrat de masque ;
un second élément (12) de maintien placé de façon à être adjacent à la surface de référence du bâti de support, pour maintenir le bâti (1) de support ;
des moyens (20-23, 26 ; 20, 22, 23) destinés à déplacer ledit substrat (2) de masque et ledit bâti (1) de support l'un par rapport à l'autre ; et
des moyens de fixation (6) destinés à fixer le substrat (2) de masque audit bâti (1) de support ;
caractérisé en ce que ledit premier élément (17) de maintien comporte des moyens (19) qui lui sont associés et qui sont destinés à appliquer une force d'attraction à ladite surface de masque pour fixer ledit substrat (2) de masque audit premier élément (17) de maintien ;
en ce que ledit second élément (12) de maintien comporte des moyens (16) qui lui sont associés et qui sont destinés à appliquer une force d'attraction à ladite surface de référence pour fixer ledit bâti (1) de support audit second élément (12) de maintien ; et
et en ce que lesdits moyens de déplacement (20-23, 26 ; 20, 22, 23) sont agencés de façon à ajuster au moins l'un de (i) l'écartement entre les premier et second éléments (17, 12) de maintien et (ii) l'inclinaison de l'un des premier et second éléments (17, 12) de maintien par rapport à l'autre, sur la base de l'un de (a) un signal de sortie d'un moyen capteur d'intervalle (25) disposés de façon à détecter un intervalle entre les premier et second éléments (17, 12) de maintien, ou (b) une entretoise (28) agissant entre les premier et second éléments (17, 12) de maintien.

8. Appareil selon la revendication 7, comportant en outre des moyens (24, 29) destinés à détecter un repère d'alignement se trouvant sur le substrat (2) de masque et un repère (9) d'alignement se trouvant sur le bâti (1) de support, et dans lequel lesdits moyens de déplacement (20-23, 26 ; 20, 22, 23) sont agencés de façon à déplacer l'un du substrat (2) de masque et du bâti (1) de support par rapport à l'autre sur la base du signal de sortie desdits moyens de détection (24, 29).

9. Appareil selon la revendication 7 ou 8, dans lequel lesdits moyens (16, 18) destinés à appliquer une force d'attraction à ladite surface de masque ou à ladite surface de référence comprennent une pompe à vide ou un dispositif d'attraction électrostatique.

10. Appareil selon la revendication 7, 8 ou 9, dans lequel ledit moyen capteur d'intervalle (25) comprend trois ou plus de trois capteurs d'intervalle.

11. Dispositif à semiconducteur fabriqué en utilisant un masque réalisé conformément au procédé de l'une quelconque des revendications 1 à 6 ou réalisé en utilisant un appareil selon l'une quelconque des revendications 7 à 10.

12. Procédé de fabrication d'un dispositif à semiconducteur, comprenant l'étape d'utilisation d'un masque réalisé conformément au procédé de l'une quelconque des revendications 1 à 6 ou réalisé en utilisant un appareil selon l'une quelconque des revendications 7 à 10 pour exposer le substrat semiconducteur.
